# EUROPEAN PATENT APPLICATION

(11) **EP 3 860 323 A1**
(43) Date of publication of application: **04.08.2021**
(21) Application number: 20204401.2
(22) Date of filing: 28.10.2020
(51) Int. Cl.: H05K 7/20

(54) **POWER MODULE ASSEMBLY**

(30) Priority: 30.01.2020 KR 20200011261
(71) Applicant: LG Electronics Inc., Yeongdeungpo-gu Seoul 07336 (KR)
(72) Inventor: HWANG, Hyunsi, 08592 Seoul (KR); CHO, Seongmoo, 08592 Seoul (KR); KIM, Kwangsoo, 08592 Seoul (KR); CHOI, Siho, 08592 Seoul (KR); LEE, Gun, 08592 Seoul (KR)
(74) Representative: Vossius & Partner Patentanwälte Rechtsanwälte mbB

(57) **Abstract**

A power module assembly is disclosed. A power module assembly according to an embodiment includes a module housing part having a power module, and an upper cover part and a lower cover part disposed to cover upper and lower sides of the module housing part, respectively, and defining a flow path part, through which cooling water flows, in spaces apart from the module housing part. The module housing part exposes a part of the power module on the flow path part. With the configuration, the cooling water can flow in direct contact with the power module, thereby more improving heat dissipation performance of the power module assembly.

## Description

### BACKGROUND

### 1. Technical Field

The present disclosure relates to a power module assembly employing a direct-cooling method using cooling water.

### 2. Description of the Related art

An eco-friendly vehicle driven by hydrogen or electricity includes a power conversion device such as an inverter. Among core components of the power conversion device, a power module assembly is constructed by a plurality of power modules. A technology for developing performance of the power module assembly is being developed along with development of the eco-friendly vehicle.

The power module provided in the power module assembly generates a large amount of heat from its electronic elements during an operation. A temperature rise of the power module directly affects performance and durability of the power module. Accordingly, as one of core technical development fields of the power module, further improvement of cooling performance of the power module is included.

Meanwhile, cooling methods of the power module are divided into single-sided cooling and double-sided cooling according to a surface to be cooled, and classified into direct-cooling and indirect-cooling according to a cooling type.

In addition, the power module assembly generally employs various types of coupling members and sealing members for mechanical assembly, which causes many limitations in reducing an overall size.

Accordingly, development of an optimized design that can further improve heat dissipation performance of the power module while more reducing the size of the power module assembly may be considered.

### SUMMARY

One aspect of the present disclosure is to provide a power module assembly configured such that cooling water flows directly on one surface or both surfaces of a power module.

Another aspect of the present disclosure is to reduce a size of a power module assembly by minimizing the use of various coupling members and sealing members for mechanical assembly of the power module assembly.

In order to achieve those aspects and other advantages of the present disclosure, there is provided a power module assembly, including a module housing part having a power module for converting power, and an upper cover part and a lower cover part disposed at upper and lower portions of the module housing part, respectively, to cover upper and lower sides of the module housing part, and defining a flow path part, through which cooling water flows, in spaces apart from the module housing part. The module housing part may expose a part of the power module on the flow path part.

At least one of the upper cover part and the lower cover part may include an inlet through which the cooling water is introduced into the flow path part, and an outlet through which the cooling water is discharged from the flow path part.

The flow path part may include a first flow path defined in a space between the upper cover part and the module housing part, and a second flow path defined in a space between the lower cover part and the module housing part. The cooling water introduced into the flow path part through the inlet may flow along the first and second flow paths and then be discharged through the outlet.

The module housing part may include an inlet hole and an outlet hole provided at positions facing the inlet and the outlet, respectively, and formed through an upper surface and a lower surface of the module housing part. The cooling water introduced into the flow path part through the inlet may flow along the first and second flow paths through the inlet hole and the outlet hole.

The inlet and the outlet may be provided at one of the upper cover part and the lower cover part.

The inlet may be provided at any one of the upper cover part and the lower cover part, and the outlet may be provided at another one of the upper cover part and the lower cover part.

The inlet and the outlet may be provided at opposite side surfaces of the module housing part.

The inlet may be provided in plurality, including a first flow path inlet and a second flow path inlet. The first flow path inlet may allow the cooling water to flow toward the first flow path. The second flow path inlet may allow the cooling water to flow toward the second flow path.

The outlet may be provided in plurality, including a first flow path outlet and a second flow path outlet. The first flow path outlet and the second flow path outlet may be located at positions facing the first and second flow paths, respectively.

The module housing part may include an upper housing and a lower housing coupled to each other to surround the power module. The upper housing and the lower housing may be implemented as a single body by insert injection molding with the power module interposed therebetween.

At least one of the upper housing and the lower housing may include a penetrating portion through which a part of the power module is exposed on the flow path part.

The at least one of the upper housing and the lower housing may further include a recess portion recessed into one surface thereof by a predetermined depth, and the penetrating portion may be provided on the recess portion.

The power module may include a dielectric layer made of a dielectric material, a metal layer portion made of a metal and bonded to at least one of both surfaces of the dielectric layer, and an electronic element provided on the metal layer portion. At least a part of the metal layer portion may be exposed on the flow path part, so that the cooling water flows in direct contact with the exposed part.

The power module may further include a cooling fin portion provided on one surface of the metal layer portion to define a cooling flow path through which the cooling water flows. At least a part of the cooling fin portion may be exposed on the flow path part, so that the cooling water flows in direct contact with the exposed parts of the cooling fin portion and the metal layer portion.

The cooling fin portion may be provided in plurality, spaced apart from one another by predetermined intervals on one surface of the metal layer portion, and extending in a second direction intersecting with a first direction in which the cooling water flows.

The module housing part may extend in one direction, and the power module may be provided in plurality, spaced apart from one another at predetermined intervals on the module housing part in the one direction in which the module housing part extends. The upper cover part and the lower cover part may be configured to define the flow path part in the one direction in which the module housing part extends.

### BRIEF DESCRIPTION OF THE DRAWINGS

FIG. 1 is a perspective view illustrating an example of a power module assembly in accordance with the present disclosure.
FIG. 2 is an exploded perspective view of the power module assembly illustrated in FIG. 1.
FIG. 3 is a conceptual diagram illustrating a cross-section taken along the line I-I illustrated in FIG. 1.
FIG. 4A is a conceptual diagram illustrating an example of an inlet and an outlet in the cross-section of the power module assembly illustrated in FIG. 3.
FIG. 4B is a conceptual diagram illustrating another example of an inlet and an outlet in the cross-section of the power module assembly illustrated in FIG. 3.
FIG. 5 is a perspective view of a module housing part illustrated in FIG. 2.
FIG. 6 is a conceptual diagram illustrating an insert injection molding process of the module housing part illustrated in FIG. 5.
FIG. 7 is a perspective view of a power module illustrated in FIG. 6.
FIG. 8 is a conceptual diagram illustrating a cross-section of the power module illustrated in FIG. 7.
FIG. 9 is a perspective view illustrating a state in which the power module assembly illustrated in FIG. 1 is mounted on a power conversion device.
FIG. 10 is a conceptual diagram illustrating a cross-section taken along the line II-II illustrated in FIG. 9.

### DETAILED DESCRIPTION OF THE EMBODIMENTS

Hereinafter, a description will be given in more detail of a power module assembly 100 according to the present disclosure, with reference to the accompanying drawings.

For the sake of brief description, the same/like components will be provided with the same/like reference numerals even in different implementations, and a redundant description thereof will be omitted.

A singular representation may include a plural representation unless it represents a definitely different meaning from the context.

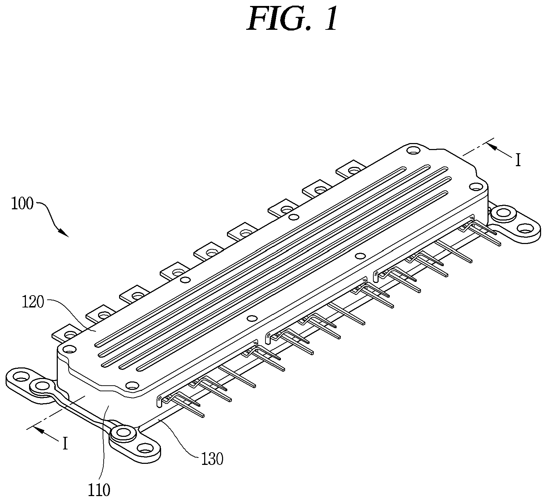

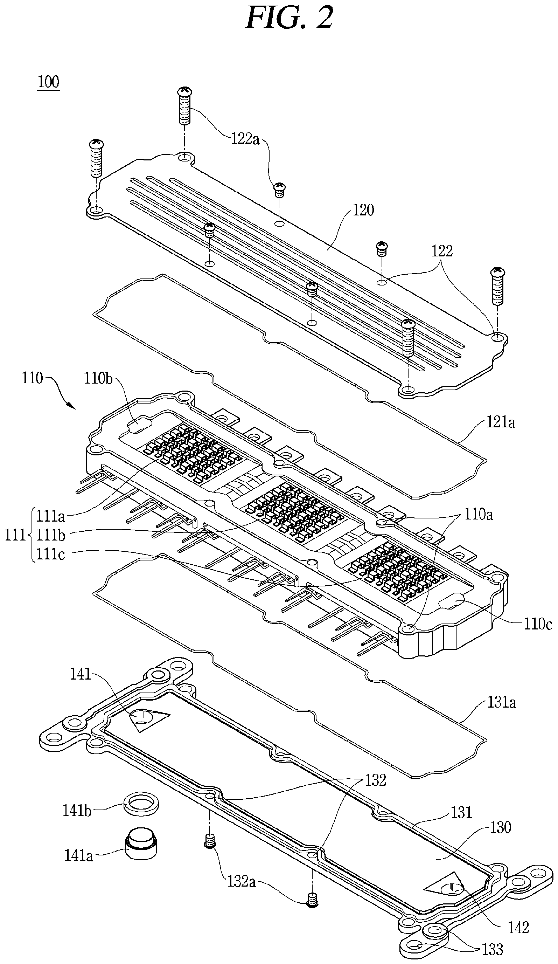

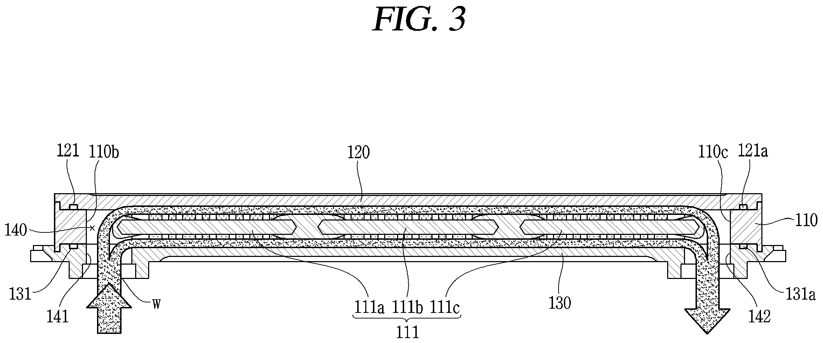

FIG. 1 is a perspective view illustrating an example of a power module assembly 100 in accordance with the present disclosure, FIG. 2 is an exploded perspective view of the power module assembly 100 illustrated in FIG. 1, and FIG. 3 is a conceptual diagram illustrating a cross-section taken along the line I-I illustrated in FIG. 1.

Referring to FIGS. 1 to 3, the power module assembly 100 is one of core components constituting a power conversion device for an eco-friendly vehicle. The power module assembly 100 may include a single power module or a plurality of power modules 111 that converts power. The power module 111 generally exhibits high heat generation during its operation. In order to suppress such a high temperature rise of the power module 111, the power module assembly 100 may have various heat dissipation mechanisms for cooling the power module 111.

The power module assembly 100 of the present disclosure includes a module housing part 110, an upper cover part 120 and a lower cover part 130.

The module housing part 110 includes a power module 111. The module housing part 110 may surround and protect the power module 111.

The power module 111 is configured to convert power. For example, the power module 111 may be configured to convert direct current (DC) to alternating current (AC), or vice versa. The power module 111 may be provided in singular or plural. In the drawings of the present disclosure, the module housing part 110 having three power modules 111 is shown. Each of the three power modules 111 may include a first power module 111a, a second power module 111b, and a third power module 111c. The first to third power modules 111a, 111b, and 111c may be configured to be equal to or different from one another in structural and/or functional aspects.

The power module 111 may alternatively be provided by two or more than four, rather than three in number. More detailed structures of the power module 111 will be described later with reference to other drawings of the present disclosure.

The upper cover part 120 and the lower cover part 130 are disposed at upper and lower portions of the module housing part 110, respectively, and are configured to cover upper and lower sides of the module housing part 110, respectively. In addition, the upper cover part 120 and the lower cover part 130 are spaced apart from the module housing part 110 so as to define spaces in which a flow path part 140 is defined. Cooling water W then flows in the flow path part 140. Here, the module housing part 110 exposes a part of the power module 111 on the flow path part 140 along which the cooling water W flows.

Meanwhile, the module housing part 110 may extend in one direction. Here, the power module 111 is provided in plurality, such as the first to third power modules 111a, 111b, and 111c, which are spaced apart at predetermined intervals on the module housing part 110 in the one direction that the module housing part 110 extends. In addition, the upper cover part 120 and the lower cover part 130 may define the flow path part 140 in the one direction in which the module housing part 110 extends.

In addition, referring to FIG. 2, coupling grooves 122 and 132 for coupling with the module housing part 110 may be formed on the upper cover part 120 and the lower cover part 130, respectively. The coupling grooves 122 and 132 may be provided in plural. Coupling members 122a and 132a may be inserted through the coupling grooves 122 and 132, respectively, to be coupled to the module housing part 110. In addition, the module housing part 110 may be provided with coupling grooves 110a that are located at positions corresponding to the coupling grooves 121 and 132, so that the coupling members 122a and 132a can be inserted therein. The coupling members 122a and 132a may be bolts. In addition, the coupling grooves 110a, 122, and 132 may be provided with threads corresponding to threads of the bolts, respectively.

In addition, sealing members 121a and 131a for sealing the flow path part 140 may be provided between the module housing part 110 and the upper cover part 120 and between the module housing part 110 and the lower cover part 130, respectively. In addition, the upper cover part 120 and the lower cover part 130 may be provided with sealing member grooves 121 and 131 respectively at positions corresponding to the sealing members 121a and 131a, so that the sealing members 121a and 131a are fixedly inserted therein.

In addition, the lower cover part 130 may be provided with fixing grooves 133 for fixing the power module assembly 110 on the power conversion device.

Meanwhile, at least one of the upper cover part 120 and the lower cover part 130 may include an inlet 141 and an outlet 142.

The inlet 141 is provided at any one of the upper cover part 120 and the lower cover part 130. The inlet 141 allows cooling water W to be introduced into the flow path part 140, thereby providing an introduction path of the cooling water W. Referring to FIG. 2, the inlet 141 may be provided with a connection pipe 141a that is engaged with the inlet 141 to define a movement path of cooling water W introduced into the inlet 141. A connection pipe ring 141b may be provided between the connection pipe 141a and the inlet 141 to prevent leakage of the cooling water W.

The outlet 142 is provided at any one of the upper cover part 120 and the lower cover part 130. The outlet 142 allows cooling water W, which has moved in at least one region of the flow path part 140, to be discharged outward, thereby defining a discharge path of the cooling water W.

According to the configuration of the power module assembly 100, the cooling water W introduced into the flow path part 140 through the inlet 141 flows in direct contact with one surface of both surfaces of the power module 111, which is provided in the module housing part 110 with being exposed to the flow path part 140. Accordingly, heat generated in the power module 111 can be more transferred to the cooling water W. This may result in greatly improving heat dissipation performance of the power module assembly 100.

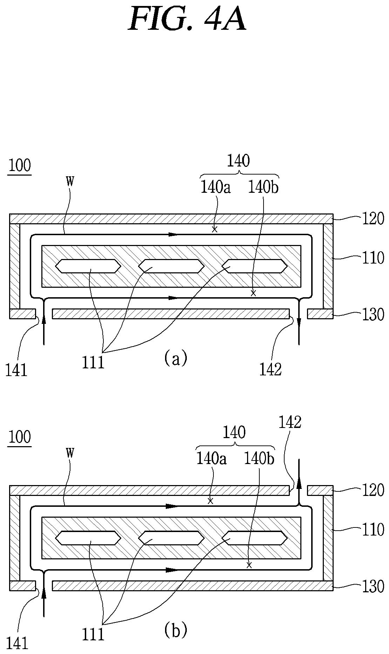

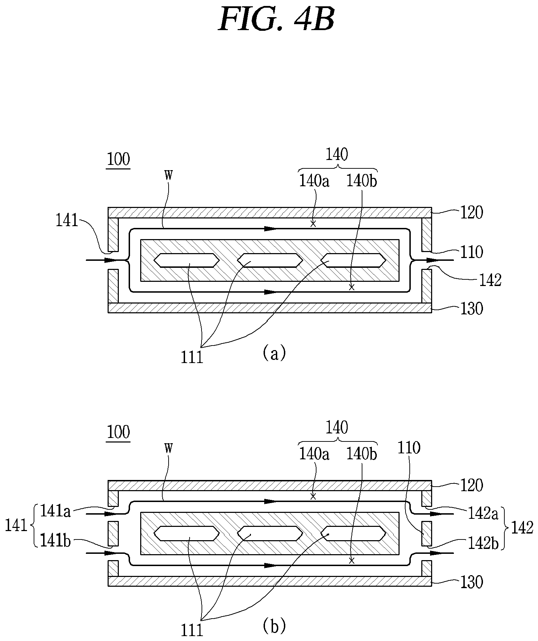

Hereinafter, examples of the inlet 141 and the outlet 142 will be described with reference to FIGS. 4A and 4B together with FIGS. 1 to 3.

FIG. 4A is a conceptual diagram illustrating an example of the inlet 141 and the outlet 142 in the cross-section of the power module assembly 100 illustrated in FIG. 3, and FIG. 4B is a conceptual diagram illustrating another example of the inlet 141 and the outlet 142 in the cross-section of the power module assembly 100 illustrated in FIG. 3.

Referring to FIGS. 1 to 4B, the flow path part 140 includes a first flow path 140a and a second flow path 140b.

The first flow path 140a is formed in a space between the upper cover part 120 and the module housing part 110. A part of the cooling water W introduced into the flow path part 140 through the inlet 141 flows into the first flow path 140a.

The second flow path 140b is formed in a space between the lower cover part 130 and the module housing part 110. Another part of the cooling water W introduced into the flow path part 140 through the inlet 141 flows into the second flow path 140b.

With the structure of the first and second flow paths 140a and 140b, the cooling water W introduced into the flow path part 140 through the inlet 141 can flow along the first and second flow paths 140a and 140b and be discharged through the outlet 142.

Meanwhile, both of the inlet 141 and the outlet 142 may be provided at any one of the upper cover part 120 and the lower cover part 130. For example, the inlet 141 and the outlet 142, as illustrated in (a) of FIG. 4A, may be provided at positions adjacent to one side and another side of the lower cover part 130, respectively. In addition, the inlet 141 and the outlet 142 may be provided at positions adjacent to a central region, rather than the one side and the another side of the lower cover part 130. In addition, the inlet 141 and the outlet 142 may be provided at the upper cover part 120, not the lower cover part 130.

Meanwhile, the inlet 141 may be provided at one of the upper cover part 120 and the lower cover part 130, and the outlet 142 may be provided at another one of the upper cover part 120 and the lower cover part 130. For example, as illustrated in (b) of FIG. 4A, the inlet 141 may be formed through the lower cover part 130 and the outlet 142 may be formed through the upper cover part 120. Here, the inlet 141 and the outlet 142, as illustrated in (b) of FIG. 4A, may be provided respectively at one side of the lower cover part 130 and another side of the upper cover part 120, which is opposite to the one side. In addition, although not illustrated in the drawings of the present disclosure, the inlet 141 and the outlet 142 may be disposed at the same one side or the same another side on the upper cover part 120 and the lower cover part 130. In addition, the inlet 141 and the outlet 142, as opposed to the example illustrated in (b) of FIG. 4A, may be disposed at the upper cover part 120 and the lower cover part 130, respectively.

Next, referring to (a) of FIG. 4B, the inlet 141 and the outlet 142 may be provided at opposite side surfaces of the module housing part 110, other than the upper cover part 120 and the lower cover part 130. With the structure of the inlet 141 and the outlet 142 as described above, unlike the inlet 141 and the outlet 142 of FIG. 4A, cooling water W introduced into the flow path part 140 can be realized to flow by the same movement distance until it is branched into the first flow path 140a and the second flow path 140b. Accordingly, the cooling water W can flow along the first flow path 140a and the second flow path 140b, respectively, while exhibiting similar flow characteristics, for example, similar flow rates, similar velocities, and the like, thereby setting similar heat transfers by the cooling water W in the first and second flow paths 140a and 140b.

As a result, a heat transfer phenomenon by cooling water W on both surfaces of the power module 111 can occur evenly over the entire region of the power module 111. On the other hand, in the case of the structure of the inlet 141 and the outlet 142 illustrated in FIG. 4A, the flow characteristics of the cooling water W may be different when flowing in the first flow path 140a and flowing in the second flow path 140b. Accordingly, the heat transfer characteristics by the cooling water W may be different on both surfaces of the power module 111.

In addition, referring to (b) of FIG. 4B, the inlet 141 disposed on a side surface of the module housing part 110 may be provided in plurality, including a first flow path inlet 141a and a second flow path inlet 141b.

Here, the first flow path inlet 141a may be formed such that cooling water W flows toward the first flow path 140a, and the second flow path inlet 141b may be formed such that cooling water W flows toward the second flow path 140b. Accordingly, the cooling water W introduced into the flow path part 140 can directly flow into the first flow path 140a or the second flow path 140b. As a result, compared to the structures of the inlet 141 and the outlet 142 illustrated in (a) and (b) of FIG. 4A and (a) of FIG. 4B, the cooling water W can flow directly into the first and second flow paths 140a and 140b. This may result in minimizing changes in the flow characteristics of the cooling water W, for example, the flow rate, the velocity, and the like.

In addition, the cooling water W introduced through the first flow path inlet 141a and the cooling water W introduced through the second flow path inlet 141b may be made independently of each other to have different flow characteristics. Accordingly, it may be designed that a heat dissipation by the cooling water W occurred in the first flow path 140a and a heat dissipation by the cooling water W occurred in the second flow path 140b are different from each other.

On the other hand, referring to (b) of FIG. 4B, the outlet 142 disposed on another side surface of the module housing part 110 may be provided in plurality, including a first flow path outlet 142a and a second flow path outlet 142b.

Here, the first flow path outlet 142a and the second flow path outlet 142b may be provided at positions facing the first and second flow paths 140a and 140b, respectively. With the structure of the first and second flow path outlets 142a and 142b, the flow of the cooling water W, which is introduced through the first and second flow path inlets 141a and 141b, flows along the first and second flow paths 140a and 140b, and then is discharged through the first and second flow path outlets 142a and 142b, may be made at positions adjacent to the first and second flow paths 140a and 140b, respectively. Accordingly, the flow characteristics of the cooling water W flowing through the first and second flow paths 140a and 140b, respectively, can be stably implemented. That is, it is possible to implement the same heat dissipation characteristic or similar heat dissipation characteristics by the cooling water W with respect to the both surfaces of the power module 111.

Meanwhile, the module housing part 110 may include an inlet hole 110b and an outlet hole 110c.

The inlet hole 110b and the outlet hole 110c may be provided at positions facing the inlet 141 and outlet 142, respectively. As illustrated in FIGS. 2 and 3, the inlet hole 110b and the outlet hole 110c may be formed through an upper surface and a lower surface of the module housing part 110, respectively.

Here, cooling water W introduced into the flow path part 140 through the inlet 141 may flow along the first and second flow paths 140a and 140b through the inlet hole 110b and the outlet hole 110c. That is, the cooling water W introduced into the flow path part 140 through the inlet 141, as illustrated in FIG. 3, may partially flow into the second flow path 140b, and the other may flow into the inlet hole 110b to be introduced into the first flow path 140a. The cooling water W passed through the first flow path 140a and the cooling water W passed through the second flow path 140b are joined with each other through the outlet hole 110c, so as to be discharged through the outlet 142. On the other hand, the flow of the cooling water W through the inlet hole 110b and the outlet hole 110c described above results from the arrangement structure of the inlet 141 and the outlet 142 illustrated in FIG. 3. Therefore, the flow of the cooling water W through the inlet hole 110b and the outlet hole 110c may differ depending on the arrangement structure of the inlet 141 and the outlet 142.

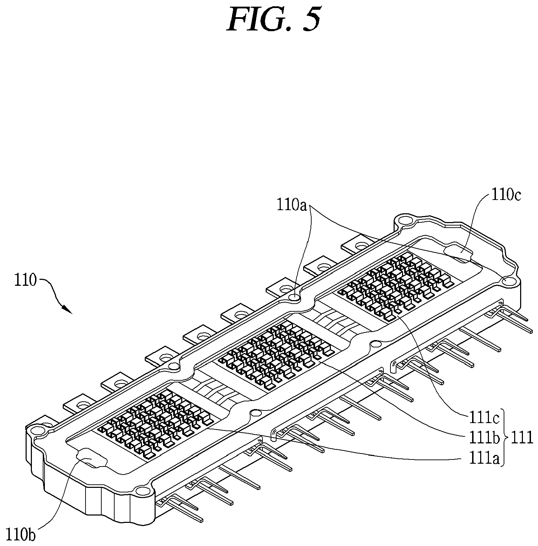

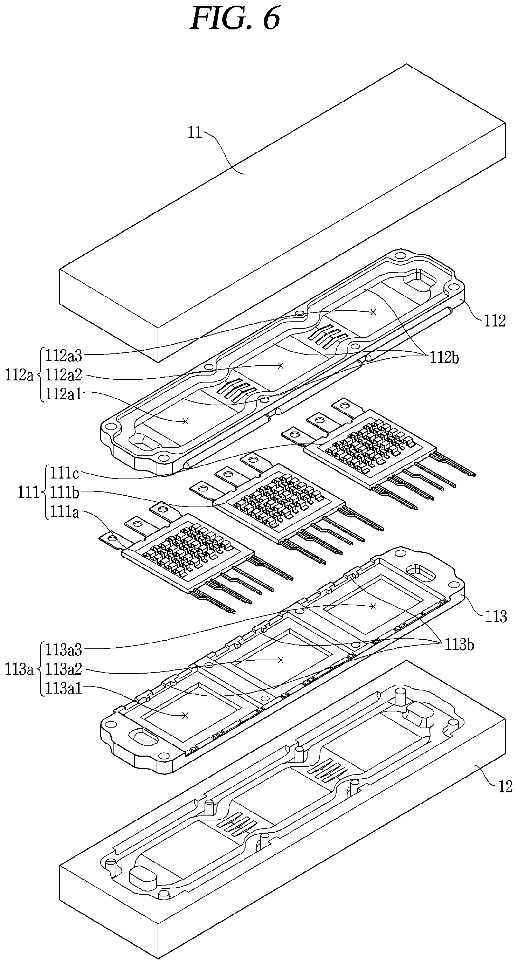

Hereinafter, the module housing part 110 implemented by insert injection molding will be described with reference to FIGS. 5 and 6.

FIG. 5 is a perspective view of the module housing part 110 illustrated in FIG. 2, and FIG. 6 is a conceptual diagram illustrating an insert injection molding process of the module housing part 110 illustrated in FIG. 5.

Referring to FIGS. 5 and 6, the module housing part 110 may include an upper housing 112 and a lower housing 113.

The upper housing 112 and the lower housing 113 are coupled to each other to surround and protect the power module 111. The power module 111 may be provided in plurality, which may include a first power module 111a, a second power module 111b, and a third power module 111c.

Here, the upper housing 112 and the lower housing 113 may have a single body formed by insert injection molding with the power module 111 interposed therebetween. The insert injection means a molding method that is carried out in a state where a component, for example, the power module 111, to be inserted into molds 11 and 12 is placed on a predetermined position. The molds 11 and 12 may include a first mold 11 corresponding to the upper housing 112 and a second mold 12 corresponding to the lower housing 113.

According to the configuration of the upper housing 112 and the lower housing 113, when manufacturing the module housing part 110 which surrounds and protects the power module 111 and is coupled with the upper cover part 120 and the lower cover part 130 for realizing the flow path part 140 in which the cooling water W flows, the use of various coupling members for mechanical assembly and/or sealing members for sealing the flow path part 140 can be excluded. Accordingly, by excluding the coupling members and/or the sealing members from the module housing part 110, an overall size of the power module assembly 100 can be more reduced.

Meanwhile, at least one of the upper housing 112 and the lower housing 113 may include penetrating portions 112a and 113a through which part of the power module 111 is exposed to the flow path part 140. The penetrating portions 112a and 113a may include a first penetrating portion 112a formed through the upper housing 112 and a second penetrating portion 113a formed through the lower housing 113. According to the configuration of the penetrating portions 112a and 113a, except for a part of the power module 111 which is in direct contact with the cooling water to perform heat transfer with the cooling water W, the remaining portion of the power module 111 can all be surrounded by the upper housing 112 and the lower housing 113. Therefore, the power module 111 can be protected more stably. In addition, the first penetrating portion 112a and the second penetrating portion 113a may include first power module penetrating portions 112a1 and 113a1, second power module penetrating portions 112a2 and 113a2, and third power module penetrating portions 112a3 and 113a3, respectively, which correspond to the respective first to third power modules 111a, 111b, and 111c.

Meanwhile, at least one of the upper housing 112 and the lower housing 113 may further include recess portions 112b and 113b recessed into one surface by a predetermined depth. The recess portions 112b and 113b may include a first recess portion 112b formed at the upper housing 112 and a second recess portion 113b formed at the lower housing 113.

Here, the penetrating portions 112a and 113a may be located at the recess portions 112b and 113b. Accordingly, the power module 111 can be disposed on the upper housing 112 and the lower housing 113 as inward as possible without a portion protruding from the upper housing 112 and the lower housing 113 configured as the single body, so as to be prevented from being damaged, for example, during a process of transferring the module housing part 110, compared with a structure in which the power module 111 protrudes outward from the upper housing 112 and the lower housing 113.

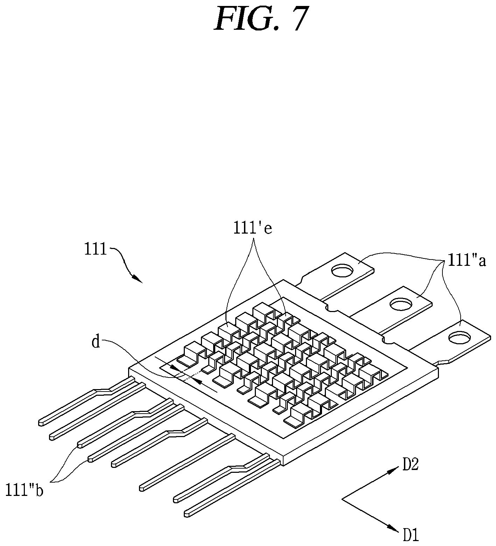

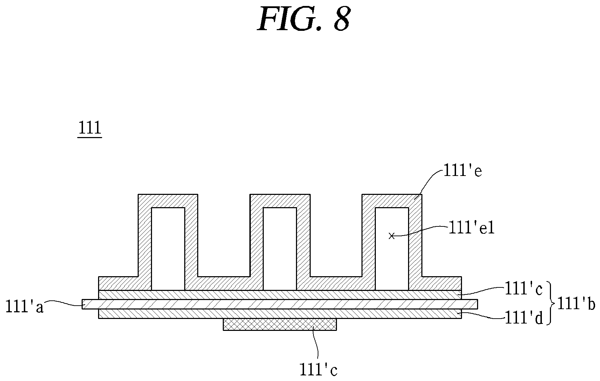

Hereinafter, a more detailed structure of the power module 111 will be described with reference to FIGS. 7 and 8.

FIG. 7 is a perspective view of the power module 111 illustrated in FIG. 6, and FIG. 8 is a conceptual diagram illustrating a cross-section of the power module 111 illustrated in FIG. 7.

Referring to FIGS. 7 and 8, the power module 111 may include a dielectric layer 111'a, a metal layer portion 111'b, and an electronic element 111'c. In addition, a first terminal portion 111"a and a second terminal portion 111"b for electrically connecting the power module 111 with other related components may be provided on one side and another side of the power module 111, respectively.

The dielectric layer 111'a may be made of an insulating material. The insulating material may include a ceramic material.

The metal layer portion 111'b may be made of a metal and may be bonded on at least one of both surfaces of the dielectric layer 111'a. For example, the metal layer portion 111'b may include a first metal layer 111'b1 and a second metal layer 111'b2, which are bonded on both surfaces of the dielectric layer 111'a, respectively. At least one of the first and second metal layers 111'b1 and 111'b2 may be made of a copper (Cu) material.

The electronic element 111'c may be provided on the metal layer portion 111'b. Also, the electronic element 111'c may be configured to perform a power conversion function of the power module 111, and may be provided in singular or plural. A solder layer (not shown) may be soldered between the electronic element 111'c and the metal layer portion 111'b so that the electronic element 111'c and the metal layer portion 111'b can be electrically connected to each other. Here, the electrical connection between the electronic element 111'c and the metal layer portion 111'b may be made in a different way, other than the soldering.

The electronic element 111'c may be configured as a power semiconductor device. The power semiconductor device may be, for example, one of an Insulated Gate Transistor (IGBT), a bipolar, and a power Metal Oxide Silicon Field Effect Transistor (MOSFET).

Here, at least a part of the metal layer portion 111'b may be exposed to the flow path part 140 so as to be in direct contact with cooling water W flowing along the flow path part 140.

Meanwhile, the power module 111 may further include a cooling fin portion 111'e provided on one surface of the metal layer portion 111'b to form a cooling flow path 111'e1 through which cooling water W flows. Here, at least a part of the cooling fin portion 111'e may be exposed on the flow path part 140 so that the cooling water W can flow in direct contact with the exposed portion as well as the metal layer portion 111'b.

On the other hand, the cooling fin portion 111'e may be provided in plurality, as illustrated in FIG. 7. The plurality of cooling fin portions 111'e may be spaced apart from one another at predetermined intervals d on one surface of the metal layer portion 111'b, and extend in a second direction D2 that intersects with a first direction D1 in which the cooling water W flows.

In addition, the cooling fin portion 111'e may be formed in various shapes such as a pin type, a ribbon type, a pipe type, and a tunnel type. The cooling fin portion 111'e may be provided with a hollow portion having an empty space therein.

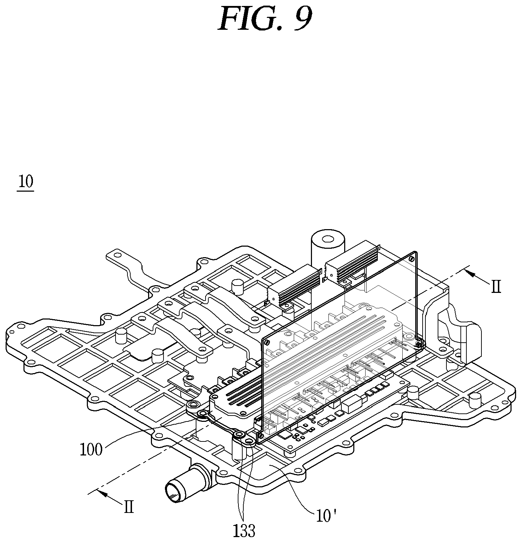

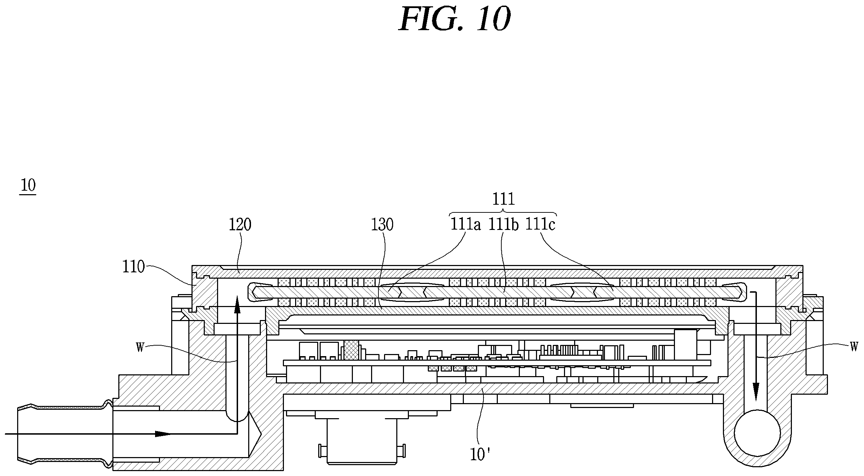

Hereinafter, the power conversion device 10 to which the power module assembly 100 is mounted will be described with reference to FIGS. 9 and 10 together with FIGS. 1 to 8.

FIG. 9 is a perspective view illustrating a state in which the power module assembly 100 illustrated in FIG. 1 is mounted on the power conversion device 10, and FIG. 10 is a conceptual diagram illustrating a cross-section taken along the line II-II illustrated in FIG. 9.

Referring to FIGS. 1 to 10, the power module assembly 100 described above may be fixedly assembled on the power conversion device 10 that is configured to perform the power conversion function. The power conversion device 10, for example, may be configured as an inverter that converts DC power into AC power.

The power conversion device 10 may include a body portion 10' to which other components constituting the power conversion device 10 as well as the power module assembly 100 can be mounted. Here, the power module assembly 100 may be disposed at a predetermined position of the body portion 10'. The power module assembly 100 may include fixing grooves 133 for fixedly coupling the power module assembly 100 on the body portion 10', and may be assembled on the body portion 10' by coupling members (not illustrated) inserted through the fixing grooves 133.

On the other hand, the power module assembly 100 can occupy a minimized space on the power conversion device 10 by virtue of the module housing part 110 that is formed as a single body by the insert injection molding. Accordingly, compared with the related art, the size of the power conversion device 10 can be greatly reduced.

According to the present disclosure having the above-described configuration, the power module assembly includes the upper cover part and the lower cover part that are disposed at the upper and lower portions of the module housing part having the power module so as to cover the upper and lower sides of the module housing part, respectively, and define the flow path part along which cooling water flows in spaces apart from the module housing part. The module housing part exposes the power module on the flow path part. Accordingly, the cooling water can be in direct contact with one surface or both surfaces of the power module, thereby greatly improving heat dissipation performance of the power module assembly.

In addition, the module housing part of the power module assembly includes the upper housing and the lower housing that are implemented as a single body by insert injection molding with the power module interposed therebetween. According to the configuration of the module housing part, various coupling members for mechanical assembly of a module housing of a power module assembly according to the related art and sealing members for sealing cooling water flow paths are not required. This may result in more reducing an overall size of the power module assembly.

## Claims

1. A power module assembly (100), comprising:
a module housing part (110) having a power module (111) for converting power; and
an upper cover part (120) and a lower cover part (130) disposed at upper and lower portions of the module housing part (110), respectively, to cover upper and lower sides of the module housing part (110), and defining a flow path part (140), through which cooling water (W) flows, in spaces apart from the module housing part (110),
wherein the module housing part (110) exposes a part of the power module (111) on the flow path part (140).

2. The power module assembly (100) of claim 1, wherein at least one of the upper cover part (120) and the lower cover part (130) comprises:
an inlet (141) through which the cooling water (W) is introduced into the flow path part (140); and
an outlet (142) through which the cooling water (W) is discharged from the flow path part (140).

3. The power module assembly (100) of claim 2, wherein the flow path part (140) comprises:
a first flow path (140a) defined in a space between the upper cover part (120) and the module housing part (110); and
a second flow path (140b) defined in a space between the lower cover part (130) and the module housing part (110), and
wherein the cooling water (W) introduced into the flow path part (140) through the inlet (141) flows along the first and second flow paths (140a, 140b) and then is discharged through the outlet (142).

4. The power module assembly (100) of claim 3, wherein the module housing part (110) comprises an inlet hole (110b) and an outlet hole (110c) provided at positions facing the inlet (141) and the outlet (142), respectively, and formed through an upper surface and a lower surface of the module housing part (110), and
wherein the cooling water (W) introduced into the flow path part (140) through the inlet (141) flows along the first and second flow paths (140a, 140b) through the inlet hole (110b) and the outlet hole (110c).

5. The power module assembly (100) of claim 3, wherein the inlet (141) and the outlet (142) are provided at one of the upper cover part (120) and the lower cover part (130).

6. The power module assembly (100) of claim 3, wherein the inlet (141) is provided at any one of the upper cover part (120) and the lower cover part (130), and
wherein the outlet (142) is provided at another one of the upper cover part (120) and the lower cover part (130).

7. The power module assembly (100) of claim 3, wherein the inlet (141) and the outlet (142) are provided at opposite side surfaces of the module housing part (110).

8. The power module assembly (100) of claim 7, wherein the inlet (141) is provided in plurality, including a first flow path inlet (141a) and a second flow path inlet (141b),
wherein the first flow path inlet (141a) allows the cooling water (W) to flow toward the first flow path (140a), and
wherein the second flow path inlet (141b) allows the cooling water (W) to flow toward the second flow path (140b).

9. The power module assembly (100) of claim 8, wherein the outlet (142) is provided in plurality, including a first flow path outlet (142a) and a second flow path outlet (142b), and
wherein the first flow path outlet (142a) and the second flow path outlet (142b) are located at positions facing the first and second flow paths (140a, 140b), respectively.

10. The power module assembly (100) of any one of claims 1 to 9, wherein the module housing part (110) comprises an upper housing (112) and a lower housing (113) coupled to each other to surround the power module (111), and
wherein the upper housing (112) and the lower housing (113) are implemented as a single body by insert injection molding with the power module (111) interposed therebetween.

11. The power module assembly (100) of claim 10, wherein at least one of the upper housing (112) and the lower housing (113) comprises a penetrating portion (112a, 113a) through which a part of the power module (111) is exposed on the flow path part (140).

12. The power module assembly (100) of claim 11, wherein the at least one of the upper housing (112) and the lower housing (113) further comprises a recess portion (112b, 113b) recessed into one surface thereof by a predetermined depth,
wherein the penetrating portion (112a, 113a) is disposed on the recess portion (112b, 113b).

13. The power module assembly (100) of any one of claims 1 to 12, wherein the power module (111) comprises:
a dielectric layer (111'a) made of a dielectric material;
a metal layer portion (111'b) made of a metal and bonded to at least one of both surfaces of the dielectric layer; and
an electronic element (111'c) provided on the metal layer portion,
wherein at least a part of the metal layer portion (111'b) is exposed on the flow path part (140), so that the cooling water (W) flows in direct contact with the exposed part.

14. The power module assembly (100) of claim 13, wherein the power module (111) further comprises:
a cooling fin portion (111'e) provided on one surface of the metal layer portion (111'b) to define a cooling flow path (111'e1) through which the cooling water (W) flows, and
wherein at least a part of the cooling fin portion (111'e) is exposed on the flow path part (140), so that the cooling water (W) flows in direct contact with the exposed parts of the cooling fin portion (111'e) and the metal layer portion (111'b).

15. The power module assembly (100) of claim 14, wherein the cooling fin portion (111'e) is provided in plurality, spaced apart from one another by predetermined intervals on one surface of the metal layer portion (111'b), and extending in a second direction intersecting with a first direction in which the cooling water (W) flows.
